Europäisches Patentamt

European Patent Office

Office européen des brevets

(19)

(11) Veröffentlichungsnummer: **0 184 627**
**A1**

(12) # EUROPÄISCHE PATENTANMELDUNG

(21) Anmeldenummer: 85112634.2

(22) Anmeldetag: 04.10.85

(51) Int. Cl.⁴: **H 05 K 3/46**

(30) Priorität: 30.10.84 DE 3439718

(43) Veröffentlichungstag der Anmeldung: **18.06.86**
**Patentblatt 86/25**

(84) Benannte Vertragsstaaten: **AT BE CH DE FR GB IT LI LU NL SE**

(71) Anmelder: **ISOLA WERKE AG, Isolastrasse 2, D-5160 Düren (DE)**

(72) Erfinder: **Hartmann, Helmut, Wilhelm-Böhler-Strasse 30, D-5166 Kreuzau-Bilstein (DE)**

(74) Vertreter: **Patentanwälte TER MEER - MÜLLER - STEINMEISTER, Mauerkircherstrasse 45, D-8000 München 80 (DE)**

(54) **Verfahren zur Herstellung von gedruckten Schaltungen mit mehr als vier Leitungsebenen.**

(57) Verfahren zur Herstellung von gedruckten Schaltungen mit mehr als vier Leitungsebenen durch unverrückbares Verbinden von Einzellaminaten (2) und Klebeprepregs (3) über im Bereich der Positionierungslöcher (5) angeordnete Stifte, Hohlniete (7), Klammern und/oder Klebefolienstücke zu einzelnen Schaltungspaketen (1), die Paket neben Paket zwischen großformatigen Klebeprepregs (3) und Kupferfolien (4) angeordnet und gemeinsam verpreßt werden.

EP 0 184 627 A1

# Beschreibung

Gegenstand der Erfindung ist ein Verfahren zur Herstellung von gedruckten Schaltungen mit mehr als vier Leitungsebenen hoher Lagegenauigkeit zwischen den Schaltungsschichten durch Verpressen einzelner Schaltungspakete aus lagegenau vorfixierten Einzellaminaten und dazwischen angeordneten Klebeprepregs zwischen Klebeprepregs und Kupferfolien.

Es ist bekannt, aus mehreren dünnen, beidseitig mit Leitungsbahnen versehenen Einzellaminaten - sogenannten Cores - aus Epoxidharz/Glasgewebe-Laminaten unter Verwendung sogenannter Klebeprepregs Mehrebenen-Schaltungen herzustellen, d. h. gedruckte Schaltungen mit mehreren Leitungsebenen. Die Herstellung solcher gedruckter Schaltungen, die in der Fachwelt auch als Multilayer bezeichnet werden, wird beispielsweise von M. Saure in "Kunststoffe in der Elektrotechnik", AEG-Telefunken Handbuch, Band 22 (1979), Seite 39 und von H. Fasbender in "Glasfaserverstärkte Kunststoffe für Mehrebenenschaltungen" aus ETZ-B-24 (1972), Band 4, Seite 77 ausführlich beschrieben.

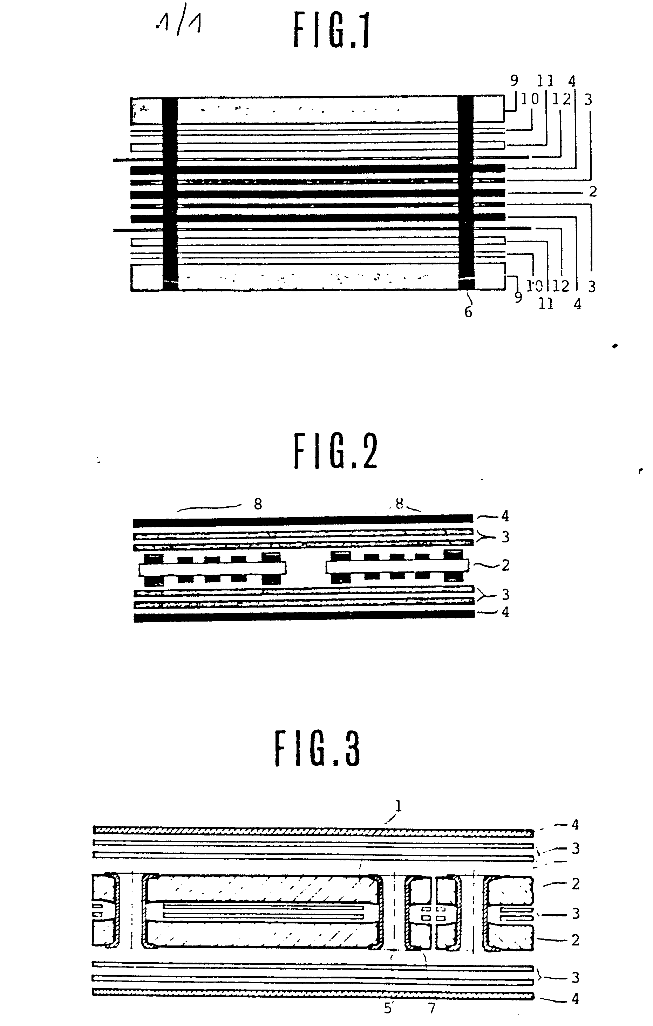

Solche gedruckten Schaltungen mit mehreren Leitungsebenen sind längst bewährte Bauteile in elektronischen Geräten, speziell Computer aller Art geworden. Eine herkömmliche Methode zur Herstellung solcher gedruckter Schaltungen mit mehreren Leitungsebenen umfaßt das individuelle Einzelpreßverfahren, bei dem ein auf die Größe der herzustellenden gedruckten Schaltung angepaßtes Werkzeug mit Fangstiften zur präzisen Positionierung der Einzellaminate eingesetzt wird. Wie in der Fig. 1 dargestellt ist, umfaßt eine solche Vorrichtung zwei einander gegenüberliegende Preßformen 9, darauf angeordnete Preßpolster 10, Preßbleche 11 und Trennfolien 12. Zwischen die Trennfolien wird zunächst die untere Kupferfolie 4, dann ein Klebeprepreg 3, anschließend das bereits mit der erforderlichen Schaltung durch Ätzen gebildete Einzellaminat 2 aufgebracht, wonach sich wiederum ein Klebeprepreg 3 und eine Kupferfolie 4 anschließen. Diese Einheiten werden mit Hilfe der Fangstifte 6 genau positioniert, worauf das gesamte Gefüge unter Wärme und Druck verpreßt wird. Diese Herstellung der Mehrebenenschaltungen nach dem Einzelpreßverfahren ist nicht nur wegen der Produktivität von Nachteil, sondern auch aufgrund der Tatsache, daß für verschieden große gedruckte Schaltungen jeweils unterschiedliche Werkzeuge benötigt werden.

Der ständig wachsende Einsatz solcher Schaltungen mit mehreren Leitungsebenen zwingt zu Rationalisierungsmaßnahmen und hat zu dem sogenannten Maß-Lam-Verfahren geführt. Bei diesem Verfahren werden ebenfalls doppelseitige, dünne Schaltungen, sogenannte Einzellaminate hergestellt, die dann in größeren Stückzahlen auf großformatigen Pressen in einem Preßvorgang gemeinsam auf großflächige Klebeprepregs und Kupferbögen verpreßt werden. Das entstehende Großlaminat wird dann wieder zu den einzelnen Schaltungen aufgeschnitten. Diese Arbeitsweise sei anhand der Fig. 2 erläutert. Wie aus der Fig. zu ersehen ist, werden die Einzellaminate 2, über Klebeprepregs 3 mit den Kupferfolien 4 schwimmend verpreßt. Die Klebefolien 8 werden dabei auf eingeätzte Markierungen, z.B. kleine Fadenkreuze, geklebt. Dadurch wird außerdem das Einzellaminat an diesen Stellen etwas dicker. Diese Verdickungen zeichnen sich auf der Oberfläche der Kupferfolie 4 ab, und man kann an diesen Stellen dann die Fadenkreuze freifräsen. Die Fadenkreuze kennzeichnen die Positionierungslöcher für die Weiterverarbeitung, d.h. für die Lage des Leitungsmusters aus den Kupferfolien 4. Bei dieser Arbeitsweise sind die zwischengelegten Einzellaminate nicht fixiert, so daß sie sich während des Preßvorgangs bewegen können. Dies stellt aber für die Verfahrensweise, die nur für die Herstellung von vierlagigen Mehrebenenschaltungen geeignet ist, kein Problem dar, da keine exakte Positionierung der
vier übereinanderliegenden Leitungsebenen beim Preßvorgang notwendig ist.

Schwierigkeiten ergeben sich jedoch dann, wenn gedruckte
Schaltungen mit mehr als vier Leitungsebenen hergestellt
werden müssen, weil in diesem Fall die innenliegenden
vier ersten Leitungsebenen genau zueinander positioniert
werden müssen, um ein Verschieben der Leitungsebenen während des Preßvorgangs gegeneinander zu verhindern. Zur
Lösung dieses Problems schlägt die DE-OS 32 40 754 vor,
jeweils zwei benachbarte Einzellaminate an mehreren Stellen mit einem Schweißmetall zu verschweißen, um sie fest
miteinander zu verbinden, wobei erforderlichenfalls eine
Metallfolie oder mehrere Metallfolien unter Zwischenschaltung eines oder mehrerer Klebeprepregs auf einer
oder beiden Seiten der gebildeten Zusammenstellung angeordnet werden, worauf die gesamte Zusammenstellung unter Erwärmen verpreßt wird. Bei dieser Arbeitsweise werden glasfaserverstärkte Epoxyharz-Einzellaminate mit auf
beiden Seiten vorliegenden gedruckten Schaltungen angeordnet, wobei jeweils Bohrungen zur lagegenauen Anordnung
zwischen den Einzellaminaten vorgesehen sind und Kupferfolienstücke an vorgegebenen Schweißstellen angebracht
sind, die gegenüber der Kupferfolie der gedruckten Schaltung isoliert sind. Die Zusammenstellung wird auf einer
Vorrichtung zur Einstellung der genauen Lage angeordnet,
wonach geschmolzenes Schweißmetall, welches einen oberhalb der Preßtemperatur liegenden Schmelzpunkt aufweist,
an den zu verschweißenden Stellen aufgebracht wird, um
die beiden Einzellaminate miteinander zu verschweißen.
Dann werden zehn derartige Anordnungen übereinander angeordnet und verpreßt, wobei man zehn Sätze von gedruckten Schaltungen mit mehr als vier Leitungsebenen erhält.
Diese Arbeitsweise ist aber wegen der zusätzlichen Anordnung der Schweißstellen, dem Aufbringen des Schweißmetalls und dem Schweißvorgang aufwendig, wobei diese Maßnahmen der Fixierung der Einzellaminate unter Bildung von Schaltungspaketen ebenfalls auf einer Positionierungslehre durchgeführt werden muß, um in dieser Weise die Lagegenauigkeit der Einzellaminate sicherzustellen.

Die Aufgabe der vorliegenden Erfindung besteht nun darin, dieses vorbekannte Verfahren zur Herstellung von gedruckten Schaltungen mit mehr als vier Leitungsebenen derart zu verbessern, daß es möglich wird, nicht nur eine Vielzahl von Einzellaminaten übereinander, sondern auch nebeneinander anzuordnen und dennoch eine lagegenaue Positionierung der Einzellaminate in den einzelnen Schaltungspaketen zu erzielen, und dies ohne die Anwendung einer Einrichtung zur Einstellung der genauen Lage.

Diese Aufgabe wird nun gelöst durch die kennzeichnenden Merkmale des Verfahrens gemäß Hauptanspruch.

Die Unteransprüche betreffen besonders bevorzugte Ausführungsformen dieses Erfindungsgegenstandes.

Die Erfindung betrifft somit ein Verfahren zur Herstellung von gedruckten Schaltungen mit mehr als vier Leitungsebenen hoher Lagegenauigkeit zwischen den Schaltungsschichten durch Verpressen einzelner Schaltungspakete aus lagegenau vorfixierten Einzellaminaten und dazwischen angeordneten Klebeprepregs zwischen Klebeprepregs und Kupferfolien, welches dadurch gekennzeichnet ist, daß einzelne Schaltungspakete aus Einzellaminaten und Klebeprepregs, die über den Bereich der Positionierungslöcher angeordnete Stifte, Hohlniete, Klammern und/oder Klebefolienstücke punktförmig unverrückbar miteinander verbunden sind, Paket neben Paket zwischen großformatigen Klebeprepregs und Kupferfolien angeordnet und gemeinsam verpreßt werden.

Die bei den erfindungsgemäßen Verfahren eingesetzten Einzellaminate bestehen vorzugsweise aus glasfaserverstärkten Epoxidharzplatten, die auf beiden Seiten eine gedruckte Schaltung aus einem Metall, vorzugsweise Kupfer, aufweisen, welches in üblicher Weise durch Ätzen oder dergleichen gebildet worden ist. Diese Einzellaminate werden mit zwischenliegenden Klebeprepregs, die vorzugsweise ebenfalls aus glasfaserverstärktem Epoxidharz bestehen, miteinander verbunden, wobei die Lagegenauigkeit der gedruckten Schaltungen der Einzellaminate in dem einzelnen Schaltungspaket erfindungsgemäß über Stifte, Hohlnieten und/oder Klammern erreicht wird, die im Bereich der Positionierungslöcher angeordnet sind. In dieser Weise wird eine provisorische, lagegenaue und unverrückbare Fixierung der Einzellaminate erreicht, so daß man Schaltungspakete erhält, in denen die einzelnen Leiterschichten exakt zueinander positioniert sind. Dabei ist es ohne weiteres möglich, Schaltungspakete aus mehr als zwei Einzellaminaten aufzubauen, so daß es ohne weiteres und in einfacher Weise gelingt, gedruckte Schaltungen mit beliebig mehr als vier Leitungsebenen zu erzeugen. Die in dieser Weise erhaltenen einzelnen Schaltungspakete werden dann nebeneinander über großflächige Klebeprepregs, die ebenfalls mit Vorteil aus glasfaserverstärktem Epoxyharz bestehen, mit großformatigen Kupferfolien verpreßt, so daß man ein Großlaminat erhält, welches dann wieder entsprechend der Größe der Schaltungspakete in einzelne gedruckte mehrlagige Schaltungen aufgeteilt wird. Ein besonderer Vorteil der erfindungsgemäßen Arbeitsweise ist darin zu sehen, daß die für die lagegenaue Positionierung der Einzellaminate verwendeten Einrichtungen, wie Stifte, Hohlniete und/oder Klammern sich nach dem Preßvorgang deutlich an der Oberfläche des Großlaminats erkennen lassen, so daß es unschwer möglich ist, die Positionierungslöcher durch Fräsen freizulegen.

Einer besonders bevorzugten Ausführungsform der Erfindung zufolge werden die Einzellaminate der Schaltungspakete dadurch lagegenau und unverrückbar fest miteinander verbunden, daß man Stifte, Hohlniete und/oder Klammern direkt in die Positionierungslöcher einführt. Dabei ist es von Vorteil, die Abmessungen der Hohlniete, Stifte und/oder Klammern an die Positionierungslöcher der Schaltungspakete anzupassen. Besonders vorteilhaft ist es, Hohlniete, Stifte und/oder Klammern zu verwenden, deren Außendurchmesser dem Innendurchmesser der Positionierungslöcher paßgenau entspricht, während ihre Länge etwas geringer, vorzugsweise 1 bis 10 % geringer, ist als die Summe der Dicken der Einzellaminate und der Klebeprepregs der erwähnten Schaltungspakete in verpreßtem Zustand. In dieser Weise wird erreicht, daß die für die lagegenaue Fixierung verwendeten Hohlniete, Stifte und/ oder Klammern etwas in der Oberfläche der Schaltungspakete versenkt sind, was etwaige Probleme beim Preßvorgang verhindert, das Freilegen der Positionierungslöcher am erhaltenen Endprodukt wesentlich erleichtert und später nach dem Freifräsen ein sauberes Ausbohren der verwendeten Hohlniete, Stifte oder Klammern erlaubt. Schließlich werden auch Preßblechdeformationen durch zu hoch stehende Nietköpfe oder Klammern vermieden.

Die Erfindung sei im folgenden näher unter Bezugnahme auf die beigefügten Zeichnungen erläutert. In der Zeichnung zeigen:

Fig. 1 eine schematische Darstellung einer herkömmlichen Methode zur Herstellung von mehrlagigen gedruckten Schaltungen;

Fig. 2 ebenfalls eine schematische Darstellung einer herkömmlichen Methode zur Herstellung von vierlagigen gedruckten Schaltungen; und

Fig. 3 eine schematische Darstellung der erfindungsgemäßen Verfahrensweise.

Wie anhand der Fig. 1 zu erkennen ist, wird eine gedruckte Schaltung mit vier Leitungsebenen dadurch hergestellt, daß in einer üblichen Presse mit Positionierungsstiften 6 ein beidseitig mit gedruckten Schaltungen versehenes Einzellaminat 2 zwischen Klebeprepregs 3 und Kupferfolien 4 verpreßt wird. Üblicherweise schließen sich an die äußeren Kupferfolien 4 Trennfolien 12, Preßbleche 11, Preßpolster 10 und die Preßform 9 an. Bei dieser herkömmlichen Arbeitsweise ist es erforderlich, für jede herzustellende gedruckte mehrlagige Schaltung eine eigene Preßform vorzusehen, da in diesem Fall die Positionierungslöcher der gedruckten Schaltung mit jenen der Preßform übereinstimmen müssen, um die Einführung der Fangstifte 6 zu ermöglichen.

Die in der Fig. 2 dargestellte herkömmliche Arbeitsweise ermöglicht ebenfalls nur die Herstellung von gedruckten Schaltungen mit vier Leitungsebenen in einem einzigen Preßvorgang, wobei die Einzellaminate 2 ebenfalls nebeneinander zwischen Klebeprepregs 3 und Kupferfolien 4 angeordnet werden, wobei zusätzliche Klebefolien 8 vorgesehen sind. Bei diesem schwimmenden Verpressen läßt sich ein seitliches Verschieben der Einzellaminate zueinander und in bezug auf die außenliegenden Kupferfolien 4 nicht zuverlässig vermeiden, was aber bei der Herstellung von vierlagigen gedruckten Schaltungen unkritisch ist, da die beiden äußersten gedruckten Schaltungslagen erst anschließend durch Ätzen erzeugt werden, so daß deren Positionierung dabei bewerkstelligt werden kann.

Bei der in der Fig. 3 schematisch dargestellten erfindungsgemäßen Verfahrensweise werden zunächst Schaltungspakete 1 aus jeweils zwei fertig mit Leitungsmuster versehenen Einzellaminaten 2 erzeugt, zwischen welchen Klebeprepregs 3 angeordnet werden. Bei der in der Fig. 3 dargestellten bevorzugten Ausführungsform der Erfindung sind die Schaltungspakete 1 über Hohlniete 7 miteinander verbunden, die in die Positionierungslöcher 5 eingeführt sind. Dadurch, daß die Klebeprepregs 3 im Kleinpaket wesentlich größer gebohrt sind als z.B. die Hohlniete es erfordern würden, und die Hohlniete eine etwas geringere Länge als die Gesamtdicke von Einzellaminaten 2 und Klebeprepregs 3 aufweisen, sind die Hohlniete etwas in der Oberfläche der Schaltungspakete 1 versenkt.

Eine Vielzahl der in dieser Weise erzeugten Schaltungspakete 1 wird dann dicht nebeneinander zwischen großformatigen Klebeprepregs 3 und Kupferfolien 4 angeordnet und in einem Preßvorgang gemeinsam zu einem Großlaminat verpreßt. Diese Großlaminate werden dann wieder in die fertigen mehrlagigen gedruckten Schaltungen aufgetrennt, die in diesem Fall sechs Leitungsebenen aufweisen.

Wenngleich bei der erfindungsgemäßen Verfahrensweise die Einzellaminate aus glasfaserverstärktem Epoxidharz und die Leitungsebenen aus Kupfer bestehen, ist es zweifellos möglich, hier auch andere übliche Materialien zu verwenden, beispielsweise polyimidharzgetränkte Glasgewebeschichten als Kernmaterial und andere Metalle als Kupfer zur Erzeugung der Leiterebenen.

Neben den oben angesprochenen Hohlnieten können zur lagegenauen Fixierung der Einzellaminate 2 unter Bildung der Schaltungspakete 1 auch Stifte, Klammern oder auch Klebefolienstücke verwendet werden. Dabei ist es besonders bevorzugt, in ihren Abmessungen an die Positionierungslöcher 5 angepaßte Hohlniete, Stifte und/oder Klammern zu verwenden, da es in dieser Weise überflüssig wird, eine Einrichtung zur lagegenauen Positionierung der Einzellaminate vorzusehen, wie es nach der Lehre der DE-OS 32 40 754 erforderlich ist. Da diese punktweise und lagegenaue Fixierung der Einzellaminate in wesentlich einfacherer Weise erfolgen kann als durch das aus der genannten Literaturstelle bekannte Verschweißen, ergibt sich eine erhebliche Steigerung der Produktivität, zumal die Anordnung einer Vielzahl solcher einzelner Schaltungspakete nebeneinander zur Bildung eines Großlaminats die Bildung einer großen Vielzahl von gedruckten Schaltungen mit mehr als vier Leitungsebenen ermöglicht, insbesondere dann, wenn mit einer entsprechenden Presse eine große Vielzahl von Großlaminaten übereinander erzeugt werden kann.

Die Erfindung sei im folgenden näher unter Bezugnahme auf die folgenden Beispiele erläutert.

B e i s p i e l   1

Herstellung einer sechslagigen gedruckten Schaltung

Zwischen zwei geätzte, doppelseitige Einzellaminate mit den Abmessungen 210 x 400 mm werden zwei Klebeprepregs mit den gleichen Abmessungen gelegt, wonach dieser Stapel mit zwei leichten Hohlnieten exakt durch die Fanglöcher vernietet wird. An der Stelle der Positionierungslöcher sind die Klebeprepregs mit Löchern versehen, die etwa 3 bis 4 mal so großen Durchmesser wie die Positionierungslöcher haben.

Auf ein Preßblech der Größe 1050 x 1200 mm werden eine Kupferfolie mit den Abmessungen 1100 x 1250 mm und darauf zwei Klebeprepregs mit den Abmessungen 1050 x 1200 mm gelegt. Auf der Klebeprepregoberfläche werden 15 der in der oben beschriebenen Weise erzeugten Schaltungspakete angeordnet und mit zwei weiteren Klebeprepregs mit den Abmessungen 1050 x 1200 mm und einer Kupferfolie mit den Abmessungen 1100 x 1250 mm abgedeckt. Auf diese Anordnung wird ein Preßblech gelegt, wonach der gleiche Aufbau mehrfach wiederholt wird. Je nach Pressenöffnung können bis zu zehn oder mehr solcher Anordnungen zu einem Großstapel zusammengestellt werden. Je nach Zahl der Preßöffnungen der verwendeten Presse sind viele solcher Großstapel möglich. Es können in dieser Weise 1000 kleine Pakete mit den Abmessungen 210 x 400 mm in einem Preßvorgang zu sechslagigem Halbzeug verpreßt werden, wobei man bei einer Presse mit 20 Öffnungen beispielsweise 3000 Stück auf einmal erhält.

Nach dem Preßvorgang erhält man 200 Großlaminate mit jeweils 15 eingepreßten Schaltungspaketen, die man leicht gewinnen kann. Die Niete zeichnen sich so gut an den äußeren Kupferflächen ab, daß die Fanglöcher der Einzelschaltungen leicht freigefräst werden können.

B e i s p i e l   2

Herstellung einer zehnlagigen gedruckten Schaltung

Man bohrt bei etwa 1800 zweilagigen mehrschichtigen gedruckten Schaltungen die Abmessungen 210 x 400 mm Positionierungslöcher und ätzt auf den äußersten Kupferschichten Leitungsmuster unter Anwendung an sich bekannter Verfahrensweisen. Zwischen vier zusammengehörigen Einzellaminaten werden dann zwei Klebeprepregs gleicher Größe eingelegt, worauf die beiden Einzellaminate durch paßgenau an die Positionierungslöcher angepaßte und in diese eingeführte Stifte unverrückbar fest miteinander unter Bildung eines Schaltungspakets verbunden werden. Auch hier sind die Klebeprepregs an den Positionierungslöchern größer gebohrt als die Positionierungslöcher. 15 solcher Schaltungspakete werden dann zwischen jeweils zwei Klebeprepregs der Abmessungen 1050 x 1200 mm und jeweils außenliegenden Kupferfolien der Größe 1100 x 1250 mm zwischen ebenso großen Preßblechen angeordnet. In einer normalen Großformatpresse kann man mehrere Hundert solcher Schaltungspakete unterbringen und durch Erwärmen auf etwa 180°C bei 45 bar während 85 Minuten verpressen. Die erhaltenen Großlaminate werden nach dem Entfernen der Preßbleche in die Einzelschaltungen mit den Abmessungen 210 x 400 mm geteilt. Man erhält zehn-

## - 77 -

lagige gedruckte Schaltungen, bei denen sich die innenliegenden Stifte so abzeichnen, daß man sie mit einem
Fräser freilegen und ohne weiteres aus den Positionierungslöchern ausstoßen kann. Die erhaltenen Produkte werden
dann in üblicher Weise auf den Außenseiten bedruckt und
mit den erforderlichen Leitungsmustern versehen.

ISOLA WERKE AG
Isolastraße 2
D - 5160 Düren

---

Verfahren zur Herstellung von gedruckten
Schaltungen mit mehr als vier Leitungsebenen

---

Priorität: 30. Oktober 1984, Bundesrepublik Deutsch-
land, Serien-Nr. P 34 39 718.3

P a t e n t a n s p r ü c h e

1.    Verfahren zur Herstellung von gedruckten Schaltungen mit mehr als vier Leitungsebenen hoher Lagegenauigkeit zwischen den Schaltungsschichten durch Verpressen
einzelner Schaltungspakete aus lagegenau vorfixierten
Einzellaminaten und dazwischen angeordneten Klebeprepregs zwischen Klebeprepregs und Kupferfolien, d a -
d u r c h   g e k e n n z e i c h n e t , daß einzelne
Schaltungspakete aus Einzellaminaten und Klebeprepregs,
die über im Bereich der Positionierungslöcher angeordnete Stifte, Hohlniete  und/oder Klammern punktförmig
unverrückbar miteinander verbunden sind, Paket neben Paket zwischen großformatigen Klebeprepregs und Kupferfolien angeordnet und gemeinsam verpreßt werden.

2. Verfahren nach Anspruch 1, d a d u r c h   g e -
k e n n z e i c h n e t , daß die Einzellaminate der
Schaltungspakete durch in die Positionierungslöcher eingeführte Stifte, Hohlniete  und/oder Klammern lagegenau
und unverrückbar miteinander verbunden werden.

3. Verfahren nach Anspruch 2, d a d u r c h   g e -
k e n n z e i c h n e t , daß die verwendeten Hohlniete,
Stifte und/oder Klammern in ihren Abmessungen den Positionierungslöchern der Schaltungspakete entsprechen.

4. Verfahren nach Anspruch 3, d a d u r c h   g e -
k e n n z e i c h n e t , daß die Außendurchmesser der
Hohlniete, Stifte und/oder Klammern dem Innendurchmesser der Positionierungslöcher paßgenau entsprechen,
während ihre Länge etwa 1 bis 10 % geringer ist als
die Summe der Dicken der Einzellaminate und Klebeprepregs der einzelnen Schaltungspakete in verpreßtem Zustand.

5. Verfahren nach Anspruch 1, d a d u r c h   g e -
k e n n z e i c h n e t , daß die Positionierungslöcher
die gleichen sind, wie die später zur Weiterverarbeitung
notwendigen.

6. Verfahren nach Anspruch 5, d a d u r c h   g e -
k e n n z e i c h n e t , daß die Nieten oder Stifte
nach dem Freifräsen ausgebohrt und entfernt werden.

# FIG.1

# FIG.2

# FIG.3

0184627

**Europäisches Patentamt**

# EUROPÄISCHER RECHERCHENBERICHT

Nummer der Anmeldung

EP 85 11 2634

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| A | US-A-4 064 357 (DIXON et al.)<br>* Figur 1, Spalte 3, Zeilen 1-66 * | 1 | H 05 K 3/46 |
| | --- | | |
| A | US-A-4 137 628 (SUZUKI)<br>* Figuren 1-8; Zusammenfassung; Spalte 4, Zeile 39 - Spalte 5, Zeile 45 * | 1,2 | |
| | --- | | |
| A,D | DE-A-3 240 754 (SUMITOMO)<br>* Figuren 1-4; Seite 4, Zeile 28 - Seite 7, Zeile 14 * | 1-3 | |
| | ----- | | |

| RECHERCHIERTE SACHGEBIETE (Int. Cl.4) |
|---|
| H 05 K 3/46 |

Der vorliegende Recherchenbericht wurde für alle Patentansprüche erstellt.

| Recherchenort<br>BERLIN | Abschlußdatum der Recherche<br>22-02-1986 | Prüfer<br>HAHN G |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82